# EUROPÄISCHE PATENTSCHRIFT

(11) **EP 2 630 653 B1**
(45) Veröffentlichungstag und Bekanntmachung des Hinweises auf die Patenterteilung: **01.04.2015**
(21) Anmeldenummer: 10770723.4
(22) Anmeldetag: 19.10.2010
(51) Int. Cl.: H01L 21/67

(54) **VORRICHTUNG ZUM BESCHICHTEN EINES WAFERS**
APPARATUS FOR COATING A WAFER
DISPOSITIF DE REVÊTEMENT D'UNE TRANCHE

(43) Veröffentlichungstag der Anmeldung: 28.08.2013
(73) Patentinhaber: EV Group GmbH, 4782 St. Florian am Inn (AT)
(72) Erfinder: BARTEL, Johanna, 94544 Hofkirchen (DE); HOLZLEITNER, Ronald, A-4644 Scharnstein (AT); HOFFMANN, Raimund, A-8561 Söding (AT); SCHRANK, Franz, A-8052 Graz (AT); TEVA, Jordi, A-8020 Graz (AT)
(74) Vertreter: Schweiger, Johannes
(86) Internationale Anmeldenummer: PCT/EP2010/006372
(87) Internationale Veröffentlichungsnummer: WO 2012/052039

(56) Entgegenhaltungen:
- WO-A1-2006/125744
- JP-A- 2003 197 716
- US-A- 6 012 858

## Beschreibung

Die Erfindung betrifft eine Vorrichtung zum Beschichten einer Oberfläche eines Wafers gemäß Patentanspruch 1.

Beim Beschichten von Wafern in Sprühbelackungsanlagen besteht das Problem der homogenen Aufbringung der Beschichtung, insbesondere des Lacks, auf die mittlerweile sehr großflächigen, beispielsweise mit einem Durchmesser von 300mm, Wafer. Als besonders problematisch erweist sich die gleichmäßig Beschichtung im Randbereich des Wafers.

Die Druckschrift US 6,012,858 A offenbart eine Vorrichtung und ein Verfahren zur Ausbildung eines Flüssigkeitsfilms auf einem Substrat.

Der Erfindung liegt daher die Aufgabe zugrunde, eine Vorrichtung zum Beschichten von Wafern anzugeben, bei der die Beschichtung, insbesondere im Randbereich des Wafers, homogener ist.

Diese Aufgabe wird mit den Merkmalen des Anspruchs 1 gelöst. Vorteilhafte Weiterbildungen der Erfindung sind in den Unteransprüchen angegeben.

Der Erfindung liegt der Gedanke zugrunde, durch Vorsehen eines zusätzlichen Bauteils in der erfindungsgemäßen Vorrichtung die Beschichtungsfläche des Wafers quasi zu erweitern, wodurch sich im Randbereich des Wafers überraschend herausgestellt hat, dass die Homogenität der durch die erfindungsgemäße Vorrichtung aufgebrachten Beschichtung insbesondere im Randbereich verbessert wird. Aus Sicht der Düseneinrichtung zur Beschichtung des Wafers wird der Randbereich des Wafers quasi auf den Ring verlagert, so dass der eigentliche Rand des Wafers und damit der gesamte Wafer homogener beschichtet wird.

Der den Wafer an einem Seitenumfang des Wafers mit seinem Innenumfang umgebende Ring zur Erweiterung der aus der Oberfläche des Wafers und einer Stirnfläche des Wafers gebildeten Beschichtungsfläche ist gemäß einer Ausführungsform mit Vorteil auswechselbar und damit auf die Außenkontur beziehungsweise die Form und Größe des Wafers anpassbar. Bei einem kreisförmigen Wafer ist der Ring demnach zumindest an seiner Innenkontur, also am Innenumfang kreisförmig.

Gemäß einer vorteilhaften Ausführungsform der Erfindung ist vorgesehen, dass der, insbesondere im Querschnitt L-förmige, Ring konzentrisch zu dem Wafer anordnenbar ist, insbesondere mit einem Abstand H zwischen dem Innenumfang und dem Seitenumfang zwischen 100 µm und 2000 µm, vorzugsweise zwischen 100 µm und 500 µm. Durch den, im Verhältnis zum Waferdurchmesser minimalen Abstand H des Wafers zwischen dem Rand des Wafers und dem Ring wird ein Verkleben des Wafers mit dem Ring vermieden, gleichzeitig außerdem eine Rotation des Wafers beim Beschichten ermöglicht. Durch die konzentrische Anordnung des Wafers zum Ring beziehungsweise des Rings zum Wafer ergibt sich ein gleichmäßiger Abstand H zwischen dem Wafer und dem Ring, der wiederum zu einem homogeneren Ergebnis der Beschichtung im Randbereich des Wafers führt. Durch die L-förmige Ausgestaltung des Rings wird Beschichtungsmaterial, das zwischen den Ring und den Wafer dringt, aufgefangen, so dass durch die erfindungsgemäße Ausgestaltung eine Reinigung der Vorrichtung erheblich erleichtert wird, indem überschüssiges Beschichtungsmaterial überwiegend am Ring haften bleibt, so dass nur der Ring gereinigt oder ausgetauscht werden muss und die übrigen Bauteile der Vorrichtung nur noch vergleichsweise selten gereinigt werden müssen.

Soweit eine obere Ringfläche des Rings oberhalb der Aufnahmefläche, insbesondere in Flucht oder oberhalb der Oberfläche, anordnenbar ist, wird die Homogenität des Beschichtungsergebnisses weiter verbessert, da das Beschichtungsmaterial nach dem Austritt aus der Düseneinrichtung insbesondere im Randbereich des Wafers gleichmäßiger auf der Oberfläche beziehungsweise der Beschichtungsfläche verteilt wird.

Mit Vorteil ist weiterhin vorgesehen, dass der Ring durch eine X-Y-Justiereinrichtung in einer parallel zur Aufnahmefläche verlaufenden X-Y-Ebene gegenüber dem Wafer justierbar ist. Durch diese erfindungsgemäße Maßnahme wird es ermöglicht, den Ring gegenüber dem, insbesondere an der Aufnahmeeinrichtung fixierten Wafer, konzentrisch auszurichten.

Alternativ ist der Ring in einer X-Y-Richtung, die orthogonal zur Z-Richtung verläuft, in der Vorrichtung fixiert, weist also nur einen Freiheitsgrad in Z-Richtung auf. Bei dieser Ausführungsform erfolgt die konzentrische Ausrichtung des Wafers zum Ring bei der Aufnahme des Wafers auf die Aufnahmefläche, indem der Wafer konzentrisch zum Ring aufgebracht wird beziehungsweise der Abstand zwischen dem Wafer und dem Ring möglichst einheitlich eingestellt wird. Die Ausrichtung des Wafers zum Ring kann durch optische Erfassungsmittel oder auf sonstige, im Stand der Technik bekannte Art und Weise erfolgen.

Gemäß einer weiteren, vorteilhaften Ausführungsform der Erfindung ist vorgesehen, dass der Ring durch eine, insbesondere in der X-Y-Justiereinrichtung in Z-Richtung gleitend geführte, Z-Justiereinrichtung in der orthogonal zur Aufnahmefläche gerichteten Z-Richtung gegenüber dem Wafer justierbar ist. Durch diese erfindungsgemäße Maßnahme ist die obere Ringfläche des Rings in der Höhe gegenüber der Oberfläche des Wafers in Z-Richtung einstellbar, so dass eine optimale Beschichtung der Oberfläche ermöglicht wird.

Indem der Ring berührungsfrei zum Wafer, vorzugsweise im wesentlichen äquidistant in Z- und/oder orthogonal zur Umfangsrichtung des Wafers, anordnenbar ist, wird die Homogenität der Beschichtung der Oberfläche des Wafers weiter verbessert.

In einer weiteren, vorteilhaften Ausführungsform der Erfindung ist vorgesehen, dass der Ring so anordnenbar ist, dass die Beschichtungsfläche aus der Oberfläche und der in Z-Richtung gerichteten oberen Ringfläche des Rings gebildet ist.

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:
- Figur 1: eine schematische, geschnittene Seitenansicht der erfindungsgemäßen Vorrichtung und
- Figur 2: eine schematische Ansicht eines erfindungsgemäßen Rings.

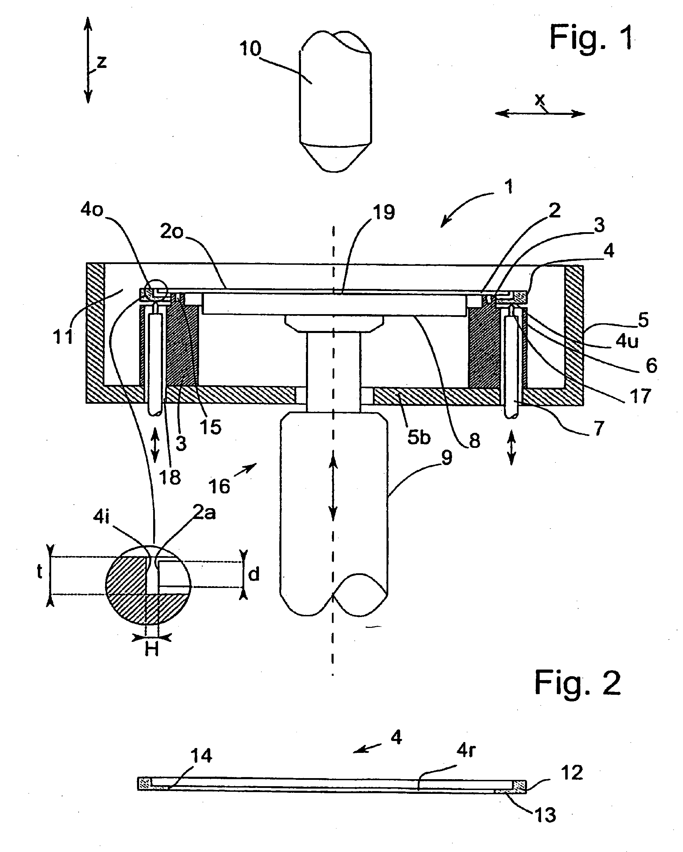

In der Figur 1 ist die erfindungsgemäße Beschichtungsvorrichtung 1 in einer Ausführungsform dargestellt, wobei ein Ausschnitt am linken Rand eines Wafers 2, der für die vorliegende Erfindung von entscheidender Bedeutung ist, vergrößert dargestellt ist.

Der Wafer 2 wird über einen nicht dargestellten Roboterarm auf einem Chuck 8 einer rotierbaren und in einer Z-Richtung höhenverstellbaren Aufnahmeeinrichtung 16 abgelegt und beim oder nach dem Ablegen und der Aufnahme auf der Aufnahmeeinrichtung zentriert gegenüber einem kreisförmigen Ring 4 ausgerichtet. Die Rotation der Aufnahmeeinrichtung 16 erfolgt durch eine Welle 9 mit einem nicht dargestellten Wellenantrieb.

Der Wafer 2 wird so auf den Chuck 8 abgelegt, dass seine Oberfläche 2o in Z-Richtung auf der vom Chuck 8 abgewandten Seite zu einer Düseneinrichtung 10 weist.

Die Düseneinrichtung 10 ist entlang der Oberfläche 2o in einer quer zur Z-Richtung verlaufenden X-Y-Ebene verfahrbar, um die gesamte Oberfläche 2o homogen mit einer Beschichtungssubstanz zu beschichten. Die Beschichtungssubstanz ist beispielsweise Fotolack.

Durch eine Gehäusewand 5 der Beschichtungsvorrichtung 1 wird ein Beschichtungsraum 11 gebildet, in welchem die Beschichtung des Wafers 2 stattfindet. Ein Boden 5b der Gehäusewand 5 ist mittig von der Welle 9 durchsetzt und die Aufnahmeeinrichtung 16 ist in Z-Richtung bewegbar.

Am Seitenumfang 2a des Wafers 2 ist der Ring 4 so anordnenbar, dass ein Innenumfang 4i des im Querschnitt L-förmigen Rings 4 so angeordnet ist, dass der Innenumfang 4i dem Seitenumfang 2a des Wafers 2 gegenüberliegt. Der Ring 4 umgibt den Wafer 2 an seinem Seitenumfang 2a vollständig, und zwar mit seinem außenliegenden Schenkel 12. Ein vom außenliegenden Schenkel 12 in Richtung der Aufnahmeeinrichtung 16 in X-Richtung und Y-Richtung weisender innenliegender Schenkel 13 des Rings erstreckt sich über den Seitenumfang 2a hinaus in Richtung des Waferzentrums und bildet eine Ringöffnung 4r, durch welche unter anderem der Chuck 8 verläuft.

Die Ringöffnung 4r wird von einer Innenringfläche 14 des Rings 4 gebildet (siehe Figur 2).

Der Ring 4 wird in X- und Y-Richtung, also in einer X-Y-Ebene durch eine X-Y-Fixierung 6 fixiert, indem ein von der X-Y-Fixierung 6 nach oben auskragender Fixierring 3 durch Anlage des Fixierrings 3 an der Innenringfläche 14 in X-Y-Richtung fixiert wird.

Der Fixierring 3 und/oder die X-Y-Fixierung 6 können am Umfang des Rings 4 an mindestens drei Stellen verteilt, also nicht umfangsgeschlossen ausgebildet sein. Entscheidend ist die Tatsache, dass die X-Y-Fixierung 6 dem Ring 4 zwei Freiheitsgrade in X- und Y-Richtung, also in der X-Y-Ebene nimmt.

Im Fixierring 3 ist außerdem eine Vakuumeinrichtung 15 vorgesehen, die zur Fixierung des Wafers 2 an der X-Y-Fixierung 6 dient.

Zur Höhenverstellung des Rings 4 ist eine Z-Justiereinrichtung 7 in Form mehrerer, am Umfang des Rings 4 angeordneter, in Z-Richtung beweglicher Stifte 17 vorgesehen, die an der zur oberen Ringfläche 4o abgewandten Unterseite 4u des Rings 4 anliegen. Die Stifte 17 sind durch die Z-Justiereinrichtung 7 gleichlaufend in Z-Richtung bewegbar, um ein Verkanten des Rings 4 an dem Fixierring 3 zu vermeiden.

Die Stifte 17 verlaufen in Führungsöffnungen 18 der X-Y-Fixierung 6, so dass die X-Y-Fixierung 6 gleichzeitig auch die Stifte 17 in X- und Y-Richtung fixiert.

Der Durchmesser des Rings 4 am Innenumfang 4i ist größer als der Durchmesser des Wafers 2 am Seitenumfang 2a, so dass ein Abstand H zwischen dem Innenumfang 4i und dem Seitenumfang 2a einstellbar ist.

Indem eine Dicke d des Wafers 2 durch die Beschichtungsvorrichtung 1 messbar ist oder bekannt ist und gleichzeitig eine Höhe t des Innenumfangs 4i vorgegeben ist, ist die obere Ringfläche 4o zu der Oberfläche 2o ausrichtbar derart, dass die obere Ringfläche 4o die Oberfläche 20 überragt oder mit dieser fluchtend in der X-Y-Ebene ausgerichtet ist.

Der Ablauf der Beschichtung mit der Beschichtungsvorrichtung 1 gemäß Ausführungsbeispiel der Figur 1 ist wie folgt:
- Einsetzen eines Rings 4 mit einem an den zu beschichtenden Wafer 2 angepassten Innenumfang 4i,
- Aufnahme des Wafers 2 auf dem Chuck 8,
- Ausrichtung des Wafers 2 konzentrisch zu dem Ring 4, so dass ein äquidistanter Abstand H zwischen dem Wafer 2 und dem Ring 4, insbesondere dem Seitenumfang 2a und dem Innenumfang 4i vorherrscht,
- gegebenenfalls Absenken der Aufnahmeeinrichtung 16, damit der Wafer 2 auf dem Fixierring 3 zu liegen kommt,
- einschließlich gegebenenfalls Fixierung des Wafers 2, insbesondere durch Ansaugen durch die Vakuumeinrichtung 15,
- Ausrichtung des Rings 4 in Z-Richtung, so dass die obere Ringfläche 4o mit der Oberfläche 2o fluchtet oder diese überragt,
- Beschichten der Oberfläche 2o mit der Düseneinrichtung 10 mit Beschichtungsmaterial durch systematisches Abfahren der Oberfläche 2o,
- Lösen des Vakuums der Vakuumeinrichtung 15 und
- Anheben des Wafers 2 in Z-Richtung durch die Aufnahmeeinrichtung 16 und Abnahme des Wafers 2 von dem Chuck 8 durch einen nicht dargestellten Roboterarm.

### Vorrichtung zum Beschichten eines Wafers

### Bezugszeichenliste

- 1: Beschichtungsvorrichtung
- 2: Wafer
- 2o: Oberfläche
- 2a: Seitenumfang
- 3: Fixierring
- 4: Ring
- 4i: Innenumfang
- 4o: obere Ringfläche
- 4r: Ringöffnung
- 5: Gehäusewand
- 5b: Boden
- 6: X-Y-Fixierung
- 7: Z-Justiereinrichtung
- 8: Chuck
- 9: Welle
- 10: Düseneinrichtung
- 11: Beschichtungsraum
- 12: außenliegender Schenkel
- 13: innenliegender Schenkel
- 14: Innenringfläche
- 15: Vakuumeinrichtung
- 16: Aufnahmeeinrichtung
- 17: Stifte
- 18: Führungsöffnungen
- 19: Aufnahmefläche
- H: Abstand
- t: Höhe
- d: Dicke

## Patentansprüche

1. Vorrichtung zum Beschichten einer Oberfläche (2o) eines Wafers (2) mit:
- einer Aufnahmeeinrichtung (16) zur Aufnahme des Wafers (2) auf einer Aufnahmefläche (19) und
- einer Düseneinrichtung (10) zur Beschichtung des Wafers (2),
- einem den Wafer (2) mit einem Innenumfang (4i) umgebender Ring (4) zur Erweiterung einer Beschichtungsfläche beim Beschichten des Wafers (2), wobei der Ring (4) an einem Seitenumfang (2a) des Wafers (2) anordenbar ist, und wobei der Ring (4) durch eine Z-Justiereinrichtung (7) in der orthogonal zur Aufnahmefläche (19) gerichteten Z-Richtung gegenüber dem Wafer (2) justierbar ist
**dadurch gekennzeichnet, dass** die Vorrichtung eine X-Y-Fixierung (6) mit einem Fixierring (3) zur Fixierung des Wafers (2) in einer parallel zur Aufnahmefläche (19) verlaufenden X- und Y-Richtung aufweist.

2. Vorrichtung nach Anspruch 1, **dadurch gekennzeichnet, dass** der, insbesondere im Querschnitt L-förmige, Ring (4) konzentrisch zu dem Wafer (2) anordenbar ist, insbesondere mit einem Abstand H zwischen dem Innenumfang (4i) und dem Seitenumfang (2a) zwischen 100 µm und 2000 µm, vorzugsweise zwischen 100 µm und 500 µm.

3. Vorrichtung nach einem der vorhergehenden Ansprüche, **dadurch gekennzeichnet, dass** eine obere Ringfläche (4o) des, insbesondere rotationssymmetrischen, Rings (4) oberhalb der Aufnahmefläche (19), insbesondere in Flucht oder oberhalb der Oberfläche (2o), anordenbar ist.

4. Vorrichtung nach einem der vorhergehenden Ansprüche, **dadurch gekennzeichnet, dass** der Ring (4) durch eine X-Y-Justiereinrichtung in einer parallel zur Aufnahmefläche verlaufenden X-Y-Ebene gegenüber dem Wafer (2) justierbar ist.

5. Vorrichtung nach einem der vorhergehenden Ansprüche, **dadurch gekennzeichnet, dass** der Ring (4) berührungsfrei zum Wafer (2), insbesondere im wesentlichen äquidistant in Z-Richtung und/oder orthogonal zur Umfangsrichtung des Wafers, anordenbar ist.

6. Vorrichtung nach einem der vorhergehenden Ansprüche, **dadurch gekennzeichnet, dass** der Ring (4) so anordenbar ist, dass die Beschichtungsfläche aus der Oberfläche (2o) und der in Z-Richtung gerichteten oberen Ringfläche (4o) des Rings (4) gebildet ist.

## Claims

1. Device for coating a surface (2o) of a wafer (2) with:
- a retaining system (16) for placing the wafer (2) on a retaining surface (19) and
- a nozzle system (10) for coating the wafer (2),
- a ring (4) that surrounds the wafer (2) with an inside periphery (4i) for expanding a coating surface when coating the wafer (2), wherein the ring (4) can be arranged on a side periphery (2a) of the wafer (2), and wherein the ring (4) can be adjusted by a Z-adjustment system (7) in the Z-direction directed orthogonally to the retaining surface (19) relative to the wafer (2),
**characterized in that** the device has a X-Y-fixation means (6) with a fixing ring (3) for fixing the wafer (2) in a X-Y-direction that runs parallel to the retaining surface (19).

2. Device according to Claim 1, wherein the ring (4), L-shaped in particular in cross-section, can be arranged concentrically to the wafer (2), in particular with a gap H between the inside periphery (4i) and the side periphery (2a) of between 100 µm and 2,000 µm, preferably between 100 µm and 500 µm.

3. Device according to one of the preceding claims, wherein an upper ring surface (4o) of the, especially rotationally symmetric, ring (4) can be arranged above the retaining surface (19), in particular aligned with or above the surface (2o).

4. Device according to one of the preceding claims, wherein the ring can be adjusted by an X-Y adjustment system in an X-Y plane that runs parallel to the retaining surface relative to the wafer (2).

5. Device according to one of the preceding claims, wherein the ring (4) can be arranged without contact on the wafer (2), in particular essentially equidistant in the Z-direction and/or orthogonal to the peripheral direction of the wafer.

6. Device according to one of the preceding claims, wherein the ring (4) can be arranged in such a way that the coating surface is formed from the surface (2o) and the upper ring surface (4o) of the ring (4) that is directed in the Z-direction.

## Revendications

1. Dispositif de revêtement d'une surface (20) d'une tranche (2) comprenant :
un dispositif de réception (16) pour recevoir la tranche (2) sur une surface de réception (19) et
- un dispositif de buse (10) pour revêtir la tranche (2),
- une bague (4) entourant la tranche (2) avec un pourtour intérieur (4i) pour élargir une surface de revêtement lors du revêtement de la tranche (2), sachant que la bague (4) peut être placée sur un pourtour latéral (2a) de la tranche (2), et sachant que la bague (4) peut être ajustée par rapport à la tranche (2) par un dispositif d'ajustement z (7) dans le sens Z orthogonal à la surface de réception (19),
**caractérisé en ce que** le dispositif présente une fixation X-Y (6) avec une bague de fixation (3) pour fixer la tranche (2) dans un sens X et Y parallèle à la surface de réception (19).

2. Dispositif selon la revendication 1, **caractérisé en ce que** la bague (4), en particulier de section en L, peut être disposée de façon concentrique à la tranche (2), en particulier avec un écart H entre le pourtour intérieur (4i) et le pourtour latéral (2a) entre 100 µm et 2000 µm, de préférence entre 100 µm et 500 µm.

3. Dispositif selon l'une des revendications précédentes, **caractérisé en ce qu'**une surface annulaire supérieure (40) de la bague (4) en particulier symétrique en rotation, peut être agencée au-dessus de la surface de réception (19), en particulier affleurant avec ou au-dessus de la surface (20).

4. Dispositif selon l'une des revendications précédentes, **caractérisé en ce que** la bague (4) peut être ajustée par rapport à la tranche (2) par un dispositif d'ajustement X-Y dans un plan X-Y parallèle à la surface de réception.

5. Dispositif selon l'une des revendications précédentes, **caractérisé en ce que** la bague (4) peut être agencée sans contact par rapport à la tranche (2), en particulier essentiellement à équidistance dans le sens Z et/ou orthogonalement au sens périphérique de la tranche.

6. Dispositif selon l'une des revendications précédentes, **caractérisé en ce que** la bague (4) peut être agencée de telle façon que la surface de revêtement est formée par la surface (20) et la surface annulaire supérieure (40) de la bague (4) dirigée dans le sens z.
